# FASCICULE DE BREVET EUROPEEN

(11) **EP 2 478 581 B1**
(45) Date de publication et mention de la délivrance du brevet: **03.09.2014**
(21) Numéro de dépôt: 10751698.1
(22) Date de dépôt: 13.09.2010
(51) Int. Cl.: H01M 8/04, G01R 31/36

(54) **DISPOSITIF DE CONTRÔLE DE TENSION POUR PILE À COMBUSTIBLE**
SPANNUNGSREGLER FÜR EINE BRENNSTOFFZELLE
VOLTAGE CONTROL DEVICE FOR A FUEL CELL

(30) Priorité: 14.09.2009 FR 0904381
(43) Date de publication de la demande: 25.07.2012
(73) Titulaire: Commissariat à l'Énergie Atomique et aux Énergies Alternatives, 75015 Paris (FR)
(72) Inventeur: CHATROUX, Daniel, F-38470 Teche (FR); DAUCHY, Julien, F-38160 Chatte (FR)
(74) Mandataire: Croonenbroek, Thomas Jakob
(86) Numéro de dépôt international: PCT/EP2010/063397
(87) Numéro de publication internationale: WO 2011/029933

(56) Documents cités:
- EP-A1- 0 777 286
- WO-A1-03/010843
- DE-A1- 2 559 364
- US-A- 3 666 562
- US-A- 5 861 812

## Description

L'invention concerne un dispositif de contrôle de tension d'une ou plusieurs cellules d'une pile à combustible.

Une pile à combustible est un générateur électrique transformant l'énergie chimique contenue dans un comburant (hydrogène, méthanol, ou autres) en une énergie électrique. Une pile à combustible se présente sous la forme d'une cellule délivrant une tension comprise entre 0,3 V et 1,2 V en fonction du type de comburant, et du courant délivré.

Afin d'obtenir de bons niveaux de tension, la pile à combustible peut comporter plusieurs cellules montées en série de manière à additionner la tension de chacune d'entre elles.

La tension d'une cellule varie en fonction de l'intensité qu'elle fournit, par exemple la tension baisse quand l'intensité fournie augmente. La tension délivrée par une cellule peut aussi varier en fonction des réactions chimiques créées dans la cellule. Les réactions sont normalement stables, mais quelque fois une perturbation peut arriver (par exemple une goutte d'eau qui s'évacue mal, etc.). La tension a alors tendance à baisser rapidement puis peut redevenir normale lorsque la perturbation est passée.

Pour ne pas dégrader une cellule, il faut que sa tension ne descende jamais en dessous d'un certain seuil. Au-delà la cellule peut connaître des échauffements et des détériorations partielles qui entraînent un vieillissement prématuré de celle-ci ou sa détérioration totale.

Selon une solution connue de l'état de la technique, on mesure de manière analogique la tension de chaque cellule et on transmet cette information à un contrôleur qui vérifie si la tension est au-dessus ou en dessous d'une tension de seuil. Le contrôleur analyse une par une la tension de chaque cellule en les scannant. Classiquement, une isolation galvanique est prévue entre la pile à combustible et le contrôleur de façon à ce que le contrôleur ne soit pas connecté à la pile à combustible en particulier si elle présente des tensions dangereuses.

Par ailleurs, dans une mise en série, le courant est le même pour toutes les cellules et est donc imposé à la cellule en défaut. II peut alors être concentré sur une partie de la surface de la membrane de la cellule de la pile à combustible et détériorer celle-ci par exemple par échauffement ou par assèchement partiel.

WO03/010843 A1 divulgue un dispositif de contrôle de tension d'une cellule d'une pile à combustible dont le but est d'éviter une dégradation de la cellule.

L'invention a donc pour objectif de permettre de surveiller de façon simple lorsqu'une cellule franchit sa tension de seuil pour empêcher la détérioration de la cellule et donc de la pile à combustible.

À cet effet, l'invention a pour objet un dispositif de contrôle de tension d'une cellule d'une pile à combustible, caractérisé en ce que ledit dispositif de contrôle comporte :
- un premier transistor présentant une seconde tension de seuil différente d'une première tension de seuil de ladite cellule, ledit premier transistor étant associé à la cellule et relié d'une part à la cellule par sa base et d'autre part à un générateur de courant, et
- une source de tension de réglage intercalée entre la cellule et le premier transistor associé, la source de tension de réglage fournissant une tension de réglage égale au différentiel de tension entre les première et seconde tensions de seuil, tels que :
   - lorsque la cellule présente une tension supérieure à la première tension de seuil, le premier transistor présente aux bornes de sa jonction base émetteur une tension supérieure à la seconde tension de seuil et conduit le courant, et
   - lorsque la cellule présente une tension inférieure à la première tension de seuil, le premier transistor présente aux bornes de sa jonction base émetteur une tension inférieure à la seconde tension de seuil et bloque la transmission du courant.

Dès que la cellule franchit sa tension de seuil, la transmission du courant est interrompue.

Le dispositif de contrôle de tension peut en outre comporter une ou plusieurs caractéristiques suivantes, prises séparément ou en combinaison :
- ledit dispositif de contrôle est configuré pour détecter le franchissement de la première tension de seuil d'au moins une cellule d'une pluralité de cellules mises en série de la pile à combustible, et ledit dispositif de contrôle comporte :
   - une pluralité de premiers transistors respectivement montés en parallèle d'une cellule associée de la pile à combustible en étant reliés par leurs bases à la cellule associée, et
   - une pluralité de seconds transistors de seconde tension de seuil, lesdits seconds transistors étant respectivement reliés par leurs bases aux collecteurs des premiers transistors, montés en série les uns aux autres de sorte qu'un second transistor soit relié par son émetteur au collecteur d'un second transistor consécutif, et montés en série avec le générateur de courant, de manière à bloquer la transmission du courant lorsqu'une cellule présente une tension inférieure à la première tension de seuil,
- ladite source de tension de réglage est formée d'une source de courant de réglage et d'une résistance,
- la source de courant de réglage comprend une source de tension fixe et une résistance,
- la source de tension fixe est réalisée par un nombre prédéterminé de cellules de la pile, une diode Zener, et une résistance,
- la tension aux bonnes desdites cellules est supérieure à la tension de Zener de la diode Zener,
- le générateur de courant est un générateur de courant à transistor comprenant :
   - un transistor,
   - une première résistance montée en série avec le transistor et reliée ,à l'émetteur du transistor,
   - une seconde résistance reliée à la base du transistor pour limiter le courant traversant le transistor,
   - une source de tension,
   - une diode Zener en série avec la seconde résistance, montées en parallèle de la source de tension, la diode Zener présentant à ses bornes une tension constante, et étant reliée à la première résistance et à la base du transistor,
- la source de tension du générateur de courant est formée par un nombre prédéterminé de cellules de la pile à combustible, tel que la tension aux bornes desdites cellules soit supérieure à la tension de Zener de la diode Zener,
- ledit dispositif de contrôle comporte une résistance de fin de chaîne de courant montée en série avec le générateur de courant, pour transformer l'information de courant en une information de tension, et
- ledit dispositif comporte un optocoupleur de fin de chaîne de courant monté en série avec le générateur de courant, pour assurer une isolation galvanique.

D'autres caractéristiques et avantages de l'invention ressortiront de la description suivante, donnée à titre d'exemple, sans caractère limitatif, en regard des dessins annexés parmi lesquels :
- la figure 1 représente de façon schématique un circuit de contrôle de franchissement de la tension de seuil d'une cellule d'une pile à combustible n'appartenant pas à l'invention
- la figure 2a est un premier exemple de réalisation d'un circuit de contrôle de franchissement de la tension de seuil de cellules d'une pile à combustible mises en série n'appartenant pas à l'invention
- la figure 2b est un deuxième exemple de réalisation d'un circuit de contrôle de franchissement de la tension de seuil de cellules d'une pile à combustible mises en série n'appartenant pas à l'invention
- la figure 2c est un troisième exemple de réalisation d'un circuit de contrôle de franchissement de la tension de seuil de cellules d'une pile à combustible mises en série n'appartenant pas à l'invention
- la figure 2d est un quatrième exemple de réalisation d'un circuit de contrôle de franchissement de la tension de seuil de cellules d'une pile à combustible mises en série n'appartenant pas à l'invention
- la figure 3a illustre un générateur de courant à transistor,
- la figure 3b représente un circuit de contrôle n'appartenant pas à l'invention de franchissement de la tension de seuil de cellules d'une pile à combustible mises en série comprenant le générateur de courant à transistor de la figure 3a
- la figure 4 illustre de façon schématique un second mode de réalisation du circuit de contrôle comprenant une source de tension de réglage
- la figure 5 est un schéma représentant une première variante de réalisation de la source de tension de réglage de la figure 4,
- la figure 6 est un schéma représentant une deuxième variante de réalisation de la source de tension de réglage de la figure 4,
- la figure 7 est un schéma représentant une troisième variante de réalisation de la source de tension de réglage de la figure 4, et
- la figure 8 représente schématiquement un circuit de contrôle de franchissement de la tension de seuil de cellules d'une pile à combustible mises en série, comprenant une source de tension de réglage selon la troisième variante de la figure 7.

Dans ces figures, les éléments identiques portent les mêmes références.

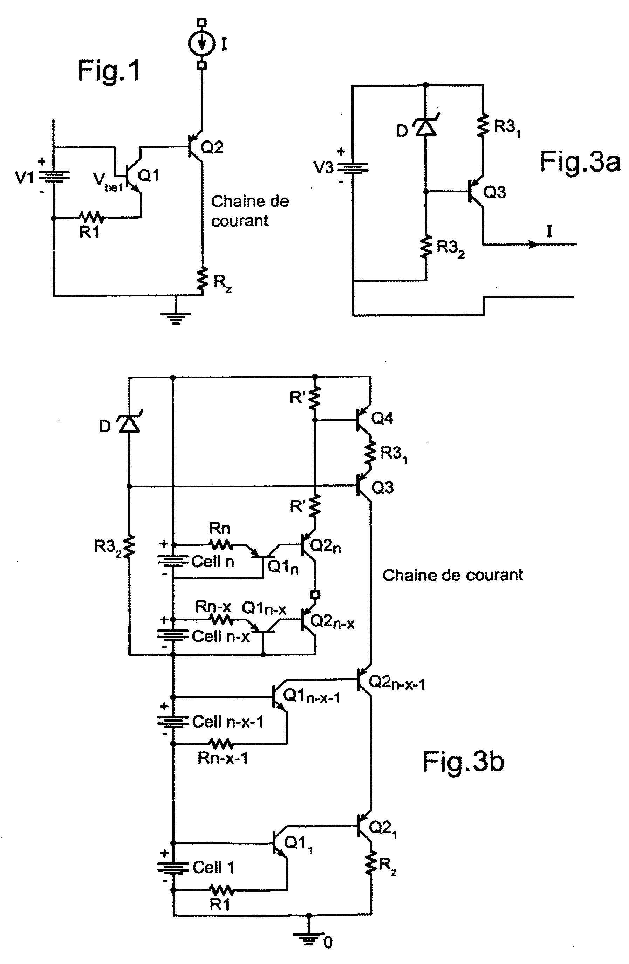

La figure 1 illustre un premier exemple de circuit de contrôle de la tension V1 d'une cellule d'une pile à combustible n'appartenant pas à l'invention. À titre d'exemple, la tension de seuil de la cellule est 0,6 V.

Un premier transistor Q1 est monté en parallèle de la cellule. Dans cet exemple, le premier transistor Q1 est un transistor NPN dont la base est reliée au pôle positif + de la cellule et l'émetteur au pôle négatif - de la cellule. Bien entendu, on peut également prévoir un transistor PNP

Selon un premier mode de réalisation, la tension de seuil du premier transistor Q1 est la même que celle de la cellule, à savoir 0,6V dans cet exemple.

La tension aux bornes de la jonction base émetteur Vbel du premier transistor Q1 est tributaire de la tension V1 de la cellule.

Ainsi, lorsque la tension V1 de la cellule est supérieure à la tension de seuil (V1>0,6V), il n'y a pas de danger de détérioration de la cellule, le premier transistor Q1 présente une tension aux bornes de sa jonction base émetteur Vbe1 supérieure à 0.6V (Vbe1>0,6V). Le premier transistor Q1 est donc passant.

Au contraire, lorsque la tension V1 de la cellule est inférieure à 0,6V (V1<0,6V), il y a un danger pour la cellule. La tension aux bornes de la jonction base émetteur du premier transistor Q1 est alors également inférieure à 0,6V (Vbe1<0,6V et est alors insuffisante pour que le premier transistor Q1 soit passant. Le premier transistor Q1 est donc bloqué.

Comme on le constate sur la figure 1, le premier transistor est également relié à un générateur de courant I par exemple par l'intermédiaire d'un second transistor Q2 monté en série avec le générateur de courant I sur une chaîne de courant. Plus précisément, le second transistor Q2, ici un transistor PNP, est relié par sa base au collecteur du premier transistor Q1 et par son émetteur au générateur de courant I.

Ainsi, lorsque le premier transistor Q1 présente une tension Vbe1 supérieure à 0,6V et est donc passant, le premier transistor entraîne la saturation du second transistor Q2 qui devient passant à son tour, ce qui autorise le passage d'un courant I délivré par le générateur de courant I.

Au contraire, lorsque le premier transistor Q1 présente une tension Vbe1 inférieure à 0,6V et est donc bloqué, le courant le traversant est interrompu, ce qui entraîne le blocage du second transistor Q2. II n'y a donc plus de courant qui circule dans la chaîne de courant. La transmission de courant est interrompue.

En outre, afin de limiter le courant dans le premier transistor Q1 et le second transistor Q2, on peut prévoir une résistance R1 intercalée entre l'émetteur du premier transistor Q1 et la cellule.

Par ailleurs, en fin de chaîne de courant, l'information transitant sous forme de courant, peut être transformée en une information de type tension à l'aide d'une résistance Rz ou peut encore être utilisée pour alimenter un optocoupleur pour assurer une isolation galvanique.

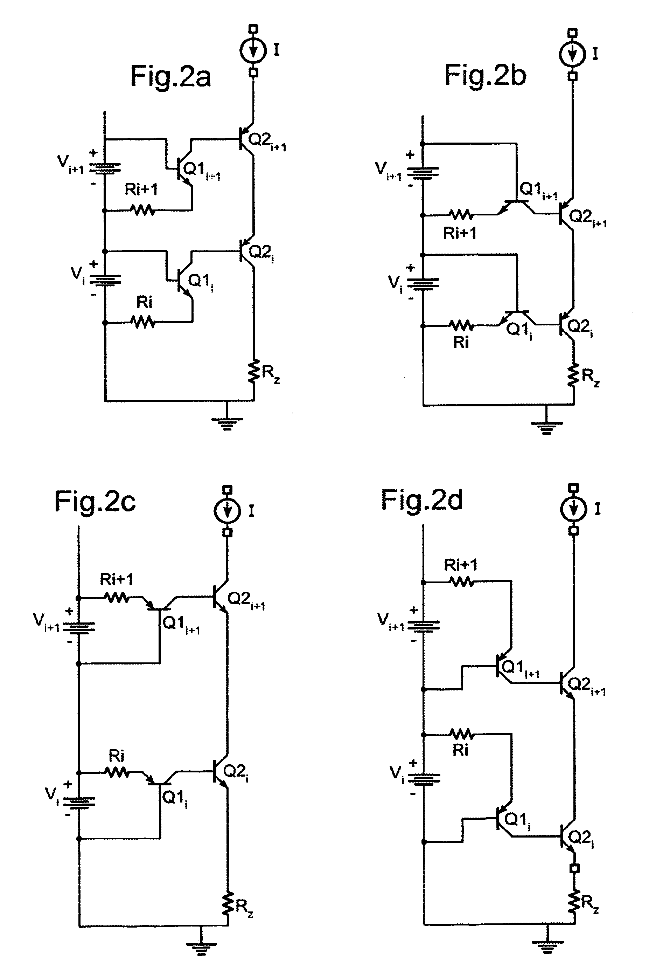

Les figures 2a à 2d, illustrent de façon schématique des variantes de réalisation du circuit de contrôle de tension n'appartenant pas à l'invention pour au moins deux cellules mises en série d'une pile à combustible de tension respective Vᵢ, Vᵢ₊₁.

Dans ce cas, pour chaque cellule, un premier transistor Q1ᵢ,Q1ᵢ₊ᵢ est monté en parallèle de la cellule associée en étant relié par sa base à la cellule associée, et un second transistor Q2ᵢ,Q2ᵢ₊₁ est relié par sa base au collecteur d'un premier transistor Q1ᵢ,Q1i+₁ associé.

L'ensemble des seconds transistors Q2ᵢ,Q2ᵢ₊₁ sont montés en série entre eux de sorte qu'un second transistor soit relié par son émetteur au collecteur d'un second transistor consécutif, et avec un générateur de courant I commun, de manière à bloquer la transmission du courant lorsqu'une cellule présente une tension inférieure à la tension de seuil.

En outre, comme précédemment une résistance unique Rz peut être montée en fin de chaîne de courant.

Les exemples illustrés sur ces figures 2a à 2d diffèrent par le dopage NPN ou PNP des premiers Q1ᵢ,Q1ᵢ₊₁ et seconds Q2ᵢ,Q2ᵢ₊₁ transistors.

Plus précisément, dans les figures 2a et 2b, les premiers transistors Q1ᵢ,Q1ᵢ₊₁ sont des transistors NPN et les seconds transistors sont des transistors PNP de façon analogue à l'exemple de la figure 1. Selon cette configuration, un second transistor Q2ᵢ est relié par son émetteur au collecteur du second transistor Q2ᵢ₊₁ consécutif supérieur.

Sur les figures 2c et 2d, les premiers transistors Q1ᵢ,Q1_{i,1} sont des transistors PNP reliés par leurs bases au pôle négatif - de la cellule et par leurs émetteurs au pôle positif + de la cellule, et les seconds transistors sont des transistors NPN tels qu'un second transistor Q2ᵢ est relié par son collecteur à l'émetteur du second transistor Q2ᵢ₊₁ consécutif supérieur.

La figure 3b illustre une variante de réalisation du circuit de contrôle n'appartenant pas à l'invention dans lequel le générateur de courant I est un générateur de courant à transistor dont le courant peut être interrompu par un transistor.

En se référant à la figure 3a, le générateur de courant à transistor comprend :
- un transistor Q3,
- une première résistance R3₁ montée en série avec le transistor Q3 et reliée à l'émetteur du transistor Q3,
- une seconde résistance R3₂ reliée à la base du transistor Q3 pour limiter le courant traversant le transistor Q3,
- une source de tension V3, et
- une diode Zener D en série avec la seconde résistance R3₂ montées en parallèle de la source de tension V3, la diode Zener D présentant à ses bornes une tension constante, et étant également reliée à la première résistance R3₁ et à la base du transistor Q3.

La diode Zener D fixe un potentiel aux bornes de la jonction du transistor Q3 et de la première résistance R3₁. Le courant circulant dans la première résistance R3₁ est égale au rapport de la différence de tension entre la diode Zener D et la jonction sur la première résistance R3₁.

Le courant I est environ le même que le courant circulant dans la première résistance R3₁. Le courant I est donc réglé en fonction de la première résistance R3₁ et de la diode Zener D.

Comme on le constate sur la figure 3b, la tension V3 peut être fournie par un nombre prédéterminé X de cellules supérieures, de la cellule Cell n-x à la cellule Cell n; la première cellule Cell 1 présentant le plus faible potentiel et la énième cellule Cell n présentant le potentiel le plus élevé. Le nombre de cellules X est défini en fonction de la tension désirée lors de la conception du générateur de courant. La tension aux bornes de ces X cellules est supérieure à la tension de Zener de la diode Zener D.

Le nombre de cellules entre la première cellule Cell 1 et la énième cellule Cell n peut être important.

Dans ce circuit, on retrouve le générateur de courant à transistor avec les composants suivants : diode Zener D, transistor Q3, résistances R3₁ et R3₂.

Ce circuit fonctionne de la même manière que celui des figures 1 à 2d. Lorsque la tension d'une cellule Cell 1 à Cell n-x-1 est au-dessus de 0.6V, le transistor Q1₁ à Q1ₙₓ₋₁ conduit, et autorise le transistor Q2₁ à Q2ₙ₋ₓ₋₁ à conduire également.

On procède de la même manière pour les X cellules Cell n-x à Cell n servant de source de tension.

En outre, un transistor Q4 est relié :
- d'une part par son émetteur à la diode Zener D et par son collecteur à la première résistance R3₁ du générateur de courant à transistor, et
- d'autre part à l'ensemble des seconds transistors en série Q2ₙ₋ₓ à Q2ₙ associés aux X cellules servant de source de tension pour le générateur de courant à transistor.

Ainsi, si l'ensemble des transistors en série Q2ₙ₋ₓ à Q2ₙ associés aux X cellules servant de source de tension sont passants, le transistor Q4 devient passant à son tour et autorise le passage du courant généré par le générateur de courant à transistor.

Par ailleurs, on prévoit des résistances R' pour limiter le courant traversant les transistors.

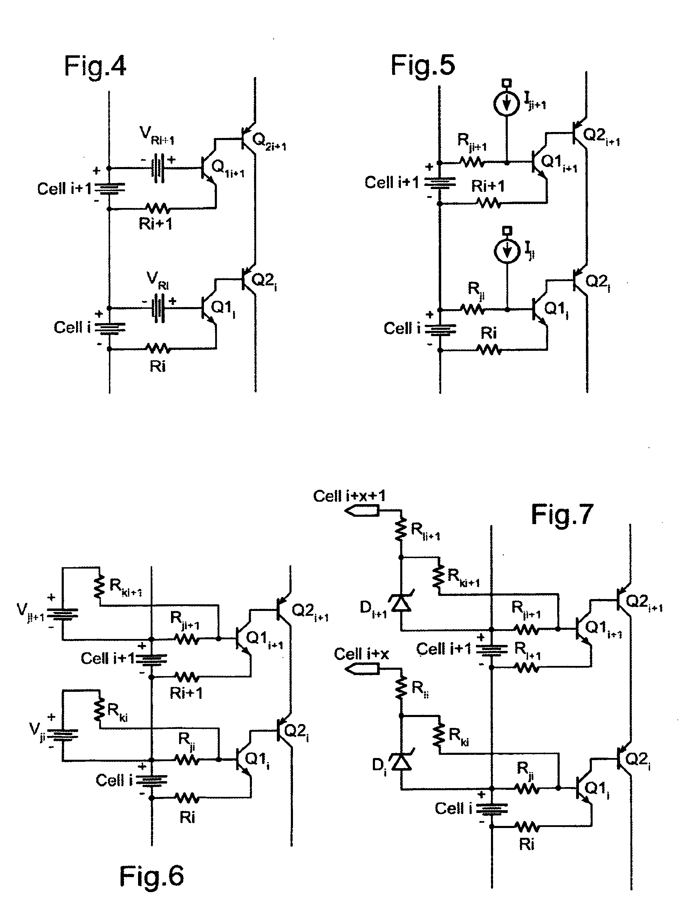

La figure 4 illustre un second mode de réalisation dans lequel la tension de seuil du premier transistor diffère de la tension de seuil de la cellule à surveiller associée.

Le dispositif de contrôle surveille alors le franchissement d'une première tension de seuil d'une cellule à l'aide d'au moins un transistor de seconde tension de seuil différente de la première tension de seuil.

Dans ce cas, le dispositif de contrôle comprend pour chaque cellule Cell i, Cell i+1, une source de tension de réglage V_{Ri}, V_{Ri+1} intercalée entre la cellule Cell i, Cell i+1 et le premier transistor Q1ᵢ, Q1i₊₁ associé. La source de tension de réglage fournit une tension réglable en fonction de la première tension de seuil de la cellule et qui s'ajoute à la tension de la cellule.

On peut donc facilement adapter la tension de seuil à surveiller.

À titre d'exemple, pour une première tension de seuil de cellule de 0,4V et une seconde tension de seuil de transistor de 0,6V, on règle la source de tension de réglage entre la cellule et le premier transistor à 0,2V

Ainsi, lorsque la tension de la cellule est supérieure à 0,4V, la tension du premier transistor aux bornes de sa jonction base émetteur est supérieure à la somme de la tension de la cellule 0,4V et de la tension de réglage 0,2V soit 0,6V

De même, lorsque la tension de la cellule est inférieure à 0,4V, la tension du premier transistor aux bornes de sa jonction base émetteur est inférieure à la somme de la tension de la cellule 0,4V et de la tension de réglage 0,2V soit 0,6V.

La figure 5 est un exemple de réalisation de la source de tension de réglage dans lequel on utilise une résistance Rⱼᵢ, Rⱼᵢ+1 et on lui injecte du courant Iⱼᵢ, Iⱼᵢ₊₁ de manière à créer une tension à ses bornes.

Selon une alternative illustrée sur la figure 6, la source de courant Iⱼᵢ, Iⱼᵢ₊₁ peut être créée en utilisant une source de tension fixe Vⱼᵢ, Vⱼᵢ₊₁ et un pont de résistance Rₖᵢ,Rⱼᵢ; Rₖᵢ₊₁, Rⱼᵢ₊₁.

En variante, on peut utiliser la tension d'un nombre prédéterminé de cellules de la pile à combustible et utiliser une diode Zener Dᵢ, Dᵢ₊₁ et une résistance Rₗᵢ, Rₗᵢ₊₁ pour obtenir une tension fixe comme illustré sur la figure 7.

La diode Zener Dᵢ, respectivement Dᵢ₊₁, sert de source de tension stable. Les résistances Rₖᵢ et Rⱼᵢ, respectivement Rₖᵢ₊₁ et Rᵢⱼ₊₁ sont utilisées comme diviseur de tension. La tension de la résistance Rⱼᵢ, respectivement Rⱼᵢ₊₁ est définie en ajustant la valeur des composants Dᵢ, Rₖᵢ et Rⱼᵢ, respectivement Dᵢ₊₁, Rₖᵢ₊₁, et Rⱼᵢ₊₁.

Pour que Dᵢ, Dᵢ₊₁ soit considérée comme une source de tension stable, il faut que la tension à ses bornes soit bien supérieure à sa tension de Zener. Il faut donc que la tension aux bornes de la cellule servant de source de tension Cell i+x, Cell i+x+1 soit supérieure à la tension Zener de la diode Zener Dᵢ,Dᵢ₊₁.

Si le nombre de cellules en série est assez grand, la cellule servant de source de tension Cell i+x, Cell i+x+1 peut être prise par exemple sur une dizaine de cellules présentant des potentiels plus élevés.

De plus, dans le cas où le nombre de cellules en série est suffisamment grand pour utiliser le potentiel d'une cellule supérieure, une difficulté se présente en ce qui concerne les cellules de potentiel élevé. Pour ces cellules à potentiel élevé, le potentiel nécessaire à créer la source de tension stable est alors pris sur les cellules présentant des potentiels moins élevés.

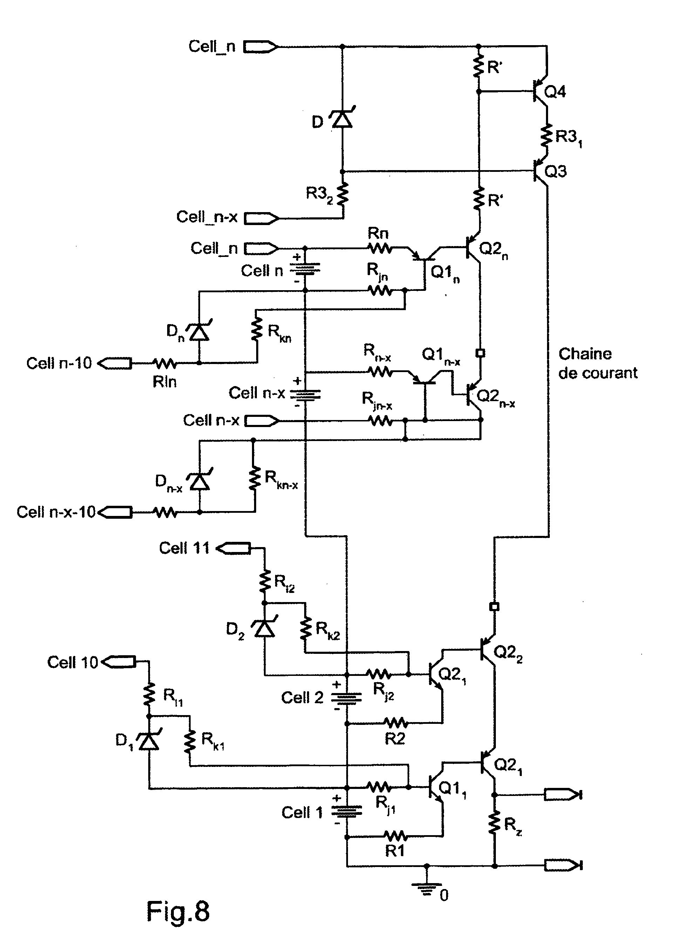

En effet, comme on le constate sur la figure 8, pour les cellules à faible potentiel comme les deux premières cellules Cell 1 et Cell 2, la diode Zener D₁,D₂ est placée entre le pôle positif + de la cellule à surveiller Cell 1, Cell 2, et le potentiel pris sur une dizaine de cellules à potentiel plus élevé, par exemple sur la dixième cellule Cell 10 pour la première cellule Cell 1, et sur la onzième cellule Cell 11 pour la deuxième cellule Cell 2.

Au contraire, pour les cellules au potentiel élevé comme les cellules Cell n à Cell n-x, la diode Zener Dₙ à _{Dn-x} est placée entre le pôle négatif - de la cellule à surveiller Cell n à Cell n-x et le potentiel pris sur une dizaine de cellules à potentiel moins élevé, par exemple sur la Cell n-10 pour la cellule Cell n, et sur la cellule Cell n-x-10 pour la cellule Cell n-x.

On comprend donc qu'avec un tel dispositif de contrôle, on peut surveiller de façon simple et efficace lorsqu'une cellule d'une pile à combustible franchit sa tension de seuil en permettant d'interrompre la transmission du courant, de façon à pouvoir empêcher la détérioration de la cellule et donc celle de la pile à combustible.

## Revendications

1. Dispositif de contrôle de tension d'une cellule d'une pile à combustible, **caractérisé en ce que** ledit dispositif de contrôle comporte :
- un premier transistor (Q1) présentant une seconde tension de seuil différente d'une première tension de seuil de ladite cellule, ledit premier transistor (Q1) étant associé à la cellule et relié d'une part à la cellule par sa base et d'autre part à un générateur de courant, et
- une source de tension de réglage (V_{Ri}) intercalée entre la cellule et le premier transistor (Q1) associé, la source de tension de réglage (V_{Ri)} fournissant une tension de réglage égale au différentiel de tension entre les première et seconde tensions de seuil, tels que :
• lorsque la cellule présente une tension (V1) supérieure à la première tension de seuil, le premier transistor (Q1) présente aux bornes de sa jonction base émetteur une tension (Vbe1) supérieure à la seconde tension de seuil et conduit le courant, et
• lorsque la cellule présente une tension (V1) inférieure à la première tension de seuil, le premier transistor (Q1) présente aux bornes de sa jonction base émetteur une tension (Vbe1) inférieure à la seconde tension de seuil et bloque la transmission du courant.

2. Dispositif de contrôle selon la revendication 1, **caractérisé en ce qu'**il est configuré pour détecter le franchissement de la première tension de seuil d'au moins une cellule d'une pluralité de cellules (Cell 1 à Cell n) mises en série de la pile à combustible, et **en ce qu'**il comporte :
- une pluralité de premiers transistors (Q1₁ à Q1ₙ) respectivement montés en parallèle d'une cellule (Cell 1 à Cell n) associée de la pile à combustible en étant reliés par leurs bases à la cellule associée (Cell 1 à Cell n), et
- une pluralité de seconds transistors (Q2₁ à Q2ₙ) de seconde tension de seuil, lesdits seconds transistors (Q2₁ à Q2ₙ) étant :
• respectivement reliés par leurs bases aux collecteurs des premiers transistors (Q1₁ à Q1ₙ),
• montés en série les uns aux autres de sorte qu'un second transistor soit relié par son émetteur au collecteur d'un second transistor consécutif, et
• montés en série avec le générateur de courant (I), de manière à bloquer la transmission du courant lorsqu'une cellule (Cell 1 à Cell n) présente une tension inférieure à la première tension de seuil.

3. Dispositif de contrôle selon l'une des revendications 1 ou 2, **caractérisé en ce que** ladite source de tension de réglage (V_{Ri}) est formée d'une source de courant de réglage (Iⱼᵢ) et d'une résistance (Rⱼᵢ).

4. Dispositif de contrôle selon la revendication 3, **caractérisé en ce que** la source de courant de réglage (Iⱼᵢ) comprend une source de tension fixe (Vⱼᵢ) et une résistance (Rₖᵢ).

5. Dispositif de contrôle selon la revendication 4, **caractérisé en ce que** la source de tension fixe est réalisée par un nombre prédéterminé de cellules de la pile, une diode Zener (Dᵢ) et une résistance (Rₗᵢ).

6. Dispositif de contrôle selon la revendication 5, **caractérisé en ce que** la tension aux bornes desdites cellules est supérieure à la tension de Zener de la diode Zener (Dᵢ).

7. Dispositif de contrôle selon l'une quelconque des revendications précédentes, **caractérisé en ce que** le générateur de courant est un générateur de courant à transistor comprenant :
- un transistor (Q3),
- unie première résistance (R3₁) montée en série avec le transistor et reliée à l'émetteur du transistor (Q3),
- une seconde résistance (R3₂) reliée à la base du transistor (Q3) pour limiter le courant traversant le transistor (Q3),
- une source de tension (V3),
- une diode Zener (D) en série avec la seconde résistance (R3₂), montées en parallèle de la source de tension (V3), la diode Zener (D) présentant à ses bornes une tension constante, et étant reliée à la première résistance (R3₁) et à la base du transistor (Q3).

8. Dispositif de contrôle selon la revendication 7, **caractérisé en ce que** la source de tension (V3) du générateur de courant est formée par un nombre prédéterminé de cellules de la pile à combustible, tel que la tension aux bornes desdites cellules soit supérieure à la tension de Zener de la diode Zener (D).

9. Dispositif de contrôle selon l'une quelconque des revendications précédentes, **caractérisé en ce qu'**il comporte une résistance (Rz) de fin de chaîne de courant montée en série avec le générateur de courant, pour transformer l'information de courant en une information de tension.

10. Dispositif de contrôle selon l'une quelconque des revendications 1 à 8, **caractérisé en ce que** ledit dispositif comporte un optocoupleur de fin de chaîne de courant monté en série avec le générateur de courant, pour assurer une isolation galvanique.

## Patentansprüche

1. Spannungssteuervorrichtung einer Zelle einer Brennstoffzelle, **dadurch gekennzeichnet, dass** die Steuervorrichtung Folgendes aufweist:
- einen ersten Transistor (Q1), der eine zweite Schwellenspannung, die von einer ersten Schwellenspannung der Zelle unterschiedlich ist, aufweist, wobei der erste Transistor (Q1) zu der Zelle gehört und einerseits mit der Zelle durch seine Basis und andererseits mit einem Stromgenerator verbunden ist, und
- eine Einstellspannungsquelle (V_{Ri}), die zwischen die Zelle und dem dazugehörenden ersten Transistor (Q1) eingefügt ist, wobei die Einstellspannungsquelle (V_{Ri}) eine Einstellspannung liefert, die gleich dem Spannungsunterschied zwischen der ersten und der zweiten Schwellenspannung derart ist, dass:
• wenn die Zelle eine Spannung (V1) aufweist, die größer ist als die erste Schwellenspannung, der erste Transistor (Q1) an den Klemmen seiner Verbindung Basis Sensor eine Spannung (Vbe1) aufweist, die größer ist als die zweite Schwellenspannung und den Strom leitet, und
• wenn die Zelle eine Spannung (V1) aufweist, die niedriger ist als die erste Schwellenspannung, der erste Transistor (Q1) an den Klemmen seiner Verbindung Basis Sensor eine Spannung (Vbe1) aufweist, die niedriger ist als die zweite Schwellenspannung und die Übertragung des Stroms blockiert.

2. Steuervorrichtung nach Anspruch 1, **dadurch gekennzeichnet, dass** sie konfiguriert ist, um das Überschreiten der ersten Schwellenspannung mindestens einer Zelle einer Vielzahl in Serie geschalteter Zellen (Cell 1 bis Cell n) der Brennstoffzelle zu erfassen, und dadurch, dass sie Folgendes aufweist:
- eine Vielzahl erster Transistoren (Q1₁ bis Q1ₙ), die jeweils parallel zu einer dazugehörenden Zelle (Cell 1 bis Cell n) der Brennstoffzelle geschaltet ist, indem sie durch ihre Basen mit der dazugehörenden Zelle (Cell 1 bis Cell n) verbunden sind, und
- eine Vielzahl zweiter Transistoren (Q2₁, bis Q2ₙ) mit zweiter Spannungsschwelle, wobei die zweiten Transistoren (Q2₁ bis Q2ₙ) :
• jeweils durch ihre Basen mit den Sammlern der ersten Transistoren (Q1₁ bis Q1ₙ) verbunden sind,
• miteinander in Serie geschaltet sind, so dass ein zweiter Transistor durch seinen Sender mit dem Sammler eines darauf folgenden zweiten Transistors verbunden ist, und
• mit dem Stromgenerator (I) derart in Serie geschaltet sind, dass die Übertragung des Stroms blockiert wird, wenn eine Zelle (Cell 1 bis Cell n) eine Spannung aufweist, die niedriger ist als die erste Spannungsschwelle.

3. Steuervorrichtung nach einem der Ansprüche 1 oder 2, **dadurch gekennzeichnet, dass** die Einstellspannungsquelle (V_{Ri}) aus einer Einstellstromquelle (Iⱼᵢ) und einem Widerstand (Rⱼᵢ) gebildet ist.

4. Steuervorrichtung nach Anspruch 3, **dadurch gekennzeichnet, dass** die Einstellstromquelle (Iⱼᵢ) eine fixe Spannungsquelle (Vⱼᵢ) und einen Widerstand (Rₖᵢ) aufweist.

5. Steuervorrichtung nach Anspruch 4, **dadurch gekennzeichnet, dass** die fixe Spannungsquelle aus einer vorbestimmten Anzahl von Zellen der Brennstoffzelle, einer Zenerdiode (Dᵢ) und einem Widerstand (Rₗᵢ) hergestellt ist.

6. Steuervorrichtung nach Anspruch 5, **dadurch gekennzeichnet, dass** die Spannung an den Klemmen der Zellen größer ist als die Zener-Spannung der Zenerdiode (Dᵢ) .

7. Steuervorrichtung nach einem der vorhergehenden Ansprüche, **dadurch gekennzeichnet, dass** der Stromgenerator ein Stromgenerator mit Transistor ist, der Folgendes aufweist:
- einen Transistor (Q3),
- einen ersten Widerstand (R3₁), der mit dem Transistor in Serie geschaltet und mit dem Sender des Transistors (Q3) verbunden ist,
- einen zweiten Widerstand (R3₂), der mit der Basis des Transistors (Q3) verbunden ist, um den Strom einzuschränken, der den Transistor (Q3) durchquert,
- eine Spannungsquelle (V3),
- eine Zenerdiode (D) mit dem zweiten Widerstand (R3₂) in Serie geschaltet, die mit der Spannungsquelle (V3) parallel geschaltet sind, wobei die Zenerdiode (D) an ihren Klemmen eine konstante Spannung aufweist und mit dem ersten Widerstand (R3₁) und der Basis des Transistors (Q3) verbunden ist.

8. Steuervorrichtung nach Anspruch 7, **dadurch gekennzeichnet, dass** die Spannungsquelle (V3) des Stromgenerators aus einer vorbestimmten Anzahl von Zellen der Brennstoffzelle gebildet ist, so dass die Spannung an den Klemmen der Zellen größer ist als die Zenerspannung der Zenerdiode (D).

9. Steuervorrichtung nach einem der vorhergehenden Ansprüche, **dadurch gekennzeichnet, dass** sie einen Stromkettenabschlusswiderstand (Rz), der mit dem Stromgenerator in Serie geschaltet ist, aufweist, um die Strominformation in eine Spannungsinformation umzuwandeln.

10. Steuervorrichtung nach einem der Ansprüche 1 bis 8, **dadurch gekennzeichnet, dass** die Vorrichtung einen Stromkettenabschlussoptokoppler in Serie mit dem Stromgenerator aufweist, um eine elektrische Isolation sicherzustellen.

## Claims

1. A device for controlling the voltage of an individual cell of a fuel cell, **characterized in that** the said control device comprises:
- a first transistor (Q1) having a second threshold voltage different from a first threshold voltage of the said individual cell, the said first transistor (Q1) being associated with the individual cell and connected on the one hand to the individual cell by its base and on the other hand to a current generator, and
- an adjustment voltage source (V_{Ri}) inserted between the individual cell and the associated first transistor (Q1), the adjustment voltage source (V_{Ri}) supplying an adjustment voltage equal to the voltage differential between the first and second threshold voltages, such that:
• when the individual cell presents a voltage (V1) greater than the first threshold voltage, the first transistor (Q1) presents at the terminals of its base-emitter junction a voltage (Vbe1) greater than the second threshold voltage and conducts the current, and
• when the individual cell presents a voltage (V1) less than the first threshold voltage, the first transistor (Q1) presents at the terminals of its base-emitter junction a voltage (Vbe1) less than the second threshold voltage and blocks the transmission of the current.

2. The control device according to Claim 1, **characterized in that** it is configured to detect the crossing of the first voltage threshold of at least one individual cell of a plurality of individual cells (Cell 1 to Cell n), placed in series, of the fuel cell, and **in that** it comprises:
- a plurality of first transistors (Q1₁ to Q1ₙ) respectively mounted in parallel with an associated individual cell (Cell 1 to Cell n) of the fuel cell by being connected by their bases to the associated individual cell (Cell 1 to Cell n), and
- a plurality of second transistors (Q2, to Q2ₙ) of second threshold voltage, said second transistors (Q2₁ to Q2ₙ) being:
• respectively connected by their bases to the collectors of the first transistors (Q1₁ to Q1n),
• mounted in series with respect to one another such that a second transistor is connected by its emitter to the collector of a consecutive second transistor and
• mounted in series with the current generator (I) so as to block the transmission of the current when an individual cell (Cell 1 to Cell n) presents a lower voltage than the first threshold voltage.

3. The control device according to one of Claims 1 or 2, **characterized in that** the said adjustment voltage source (V_{Ri}) is formed by an adjustment current source (Iⱼᵢ) and a resistor (Rⱼᵢ).

4. The control device according to Claim 3, **characterized in that** the adjustment current source (Iⱼᵢ) includes a fixed voltage source (Vⱼᵢ) and a resistor (Rₖᵢ).

5. The control device according to Claim 4, **characterized in that** the fixed voltage source is realized by a predetermined number of individual cells of the fuel cell, a Zener diode (Dᵢ) and a resistor (Rₗᵢ).

6. The control device according to Claim 5, **characterized in that** the voltage at the terminals of the said individual cells is greater than the Zener voltage of the Zener diode (Dᵢ) .

7. The control device according to any one of the preceding claims, **characterized in that** the current generator is a current generator with transistor, including:
- a transistor (Q3),
- a first resistor (R3₁) mounted in series with the transistor and connected to the emitter of the transistor (Q3),
- a second resistor (R3₂) connected to the base of the transistor (Q3) to limit the current passing through the transistor (Q3),
- a voltage source (V3),
- a Zener diode (D) in series with the second resistor (R3₂), mounted in parallel with the voltage source (V3), the Zener diode (D) having at its terminals a constant voltage, and being connected to the first resistor (R3₁) and to the base of the transistor (Q3).

8. The control device according to Claim 7, **characterized in that** the voltage source (V3) of the current generator is formed by a predetermined number of individual cells of the fuel cell, such that the voltage at the terminals of the said individual cells is greater than the Zener voltage of the Zener diode (D) .

9. The control device according to any one of the preceding claims, **characterized in that** it comprises an end-of-current-chain resistor (Rz) mounted in series with the current generator, to transform the current information into voltage information.

10. The control device according to any one of Claims 1 to 8, **characterized in that** the said device comprises an end-of-current-chain optocoupler mounted in series with the current generator, to ensure a galvanic insulation.
